**Europäisches Patentamt**

(19) **European Patent Office**

**Office européen des brevets**

(11) Numéro de publication: **0 096 625 B1**

(12) **FASCICULE DE BREVET EUROPEEN**

(45) Date de publication du fascicule du brevet:
16.07.86

(51) Int. Cl.⁴: **H 01 L 29/08, H 01 L 29/167**

(21) Numéro de dépôt: **83401076.1**

(22) Date de dépôt: **27.05.83**

(54) Structure de doigt d'émetteur dans un transistor de commutation et procédé de fabrication.

(30) Priorité: **08.06.82 FR 8209954**

(43) Date de publication de la demande:
**21.12.83 Bulletin 83/51**

(45) Mention de la délivrance du brevet:
**16.07.86 Bulletin 86/29**

(84) Etats contractants désignés:
**DE FR GB IT**

(56) Documents cités:
**EP - A - 0 011 120**
**EP - A - 0 015 835**
**FR - A - 2 374 742**
**FR - A - 2 374 743**
**GB - A - 2 026 236**

(73) Titulaire: **THOMSON-CSF, 173, Boulevard Haussmann, F-75379 Paris Cedex 08 (FR)**

(72) Inventeur: **Bouard, Philippe, THOMSON-CSF SCPI 173, bld Haussmann, F-75379 Paris Cedex 08 (FR)**

(74) Mandataire: **Guérin, Michel et al, THOMSON-CSF SCPI 19, avenue de Messine, F-75008 Paris (FR)**

## Description

La présente invention concerne le domaine des transistors et, plus particulièrement, des transistors de moyenne et forte puissance utilisés en commutation, c'est-à-dire capables de passer très rapidement de l'état conducteur à l'état bloqué.

Ces transistors présentent couramment des structures interdigitées d'émetteur et de base, c'est-à-dire que les zones d'émetteur et de base comprennent au moins partiellement des portions en forme de bandes imbriquées.

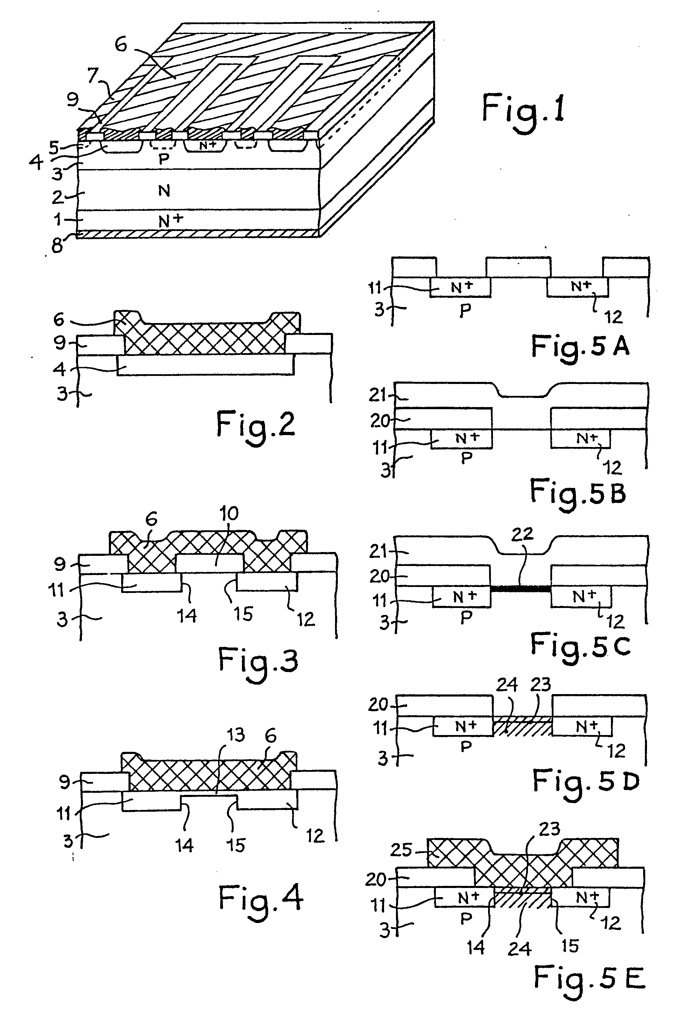

La figure 1 représente une vue partielle en coupe et en perspective d'un transistor à émetteur digité, cette vue étant schématique. Ce transistor comprend des couches de collecteur 1 et 2, de type N+ et N, et une couche de base 3 de type P, dans laquelle sont formées, généralement par diffusion, des zones d'émetteur 4 de type N+ ayant la forme de doigts allongés. Entre les doigts d'émetteur 4 on trouve éventuellement des doigts de base 5 constitués de zones de type P à niveau de dopage plus élevé que le niveau de dopage de la couche 3 de façon à favoriser l'ohmicité des contacts. Au-dessus des diffusions d'émetteur 4, se trouvent des métallisations d'émetteur 6 et, entre ces métallisations d'émetteur, se trouvent des métallisations de base 7. La face inférieure est revêtue d'une métallisation de collecteur 8. La face supérieure de la plaquette, en dehors des zones de contact avec les métallisations, est protégée par une couche d'oxyde de silicium 9 (SiO2).

La figure 2 représente une vue en coupe agrandie et schématique de la structure d'un doigt d'émetteur. On peut y voir la couche de base 3, la zone d'émetteur 4, la métallisation d'émetteur 6 et la couche d'oxyde 9. Au moment où l'on veut interrompre le passage du courant dans le transistor, ce sont les parties latérales de la zone d'émetteur qui seront affectées les premières par les courants provenant des électrodes de base adjacentes 7 et les lignes de courant se concentrent dans la partie centrale de la zone d'émetteur. Ce phénomène de concentration des lignes de courant à l'ouverture qui ralentit la commutation au blocage d'un transistor a été étudié par de nombreux auteurs sous l'appellation de focalisation des lignes de courant.

Divers remèdes ont été proposés pour pallier cet inconvénient.

Un premier remède, illustré en figure 3, consiste tout simplement à supprimer la partie centrale du doigt d'émetteur et à la recouvrir d'une couche d'oxyde 10 avant de procéder à la métallisation 6. Chaque doigt d'émetteur est alors divisé en deux doigts distincts 11 et 12 connectés par la métallisation 6, cette métallisation ayant sensiblement la même largeur et la même épaisseur que celle représentée en figure 2, la section de cette métallisation étant déterminée en fonction du courant que l'on souhaite faire passer dans l'émetteur et pour obtenir une surface sensiblement équipotentielle sur toute la surface de la zone d'émetteur. Un inconvénient de la structure de la figure 3 est que si la couche d'oxyde 10 présente un défaut (un trou), la métallisation 6 court-circuitera les zones de base et d'émetteur.

Pour éviter cet inconvénient, on a également pro-posé dans l'art antérieur la structure illustrée en figure 4 dans laquelle chaque doigt d'émetteur est également divisé en deux bandes 11 et 12, mais où une diffusion 13 d'atomes dopants de même type que ceux des zones 11 et 12 est prévue dans la partie centrale et où la métallisation 6 repose sur toute la zone d'émetteur y compris sur la partie centrale sans isolement (voir par exemple GB-A-2 026 236). On évite ainsi les éventuels court-circuits base/émetteur pouvant résulter de défauts de structure de la couche d'oxyde 10 de la figure 3. Néanmoins, la structure de la figue 4 présente l'inconvénient évident d'être moins efficace que la structure de la figure 3 du fait qu'il se produit quand même une injection au niveau de la partie centrale 13 de l'émetteur.

On notera en outre que, dans le cas des figures 3 et 4, il se produit une injection au voisinage de la zone centrale à partir des parties latérales 14 et 15 des zones d'émetteur en forme de bandes 11 et 12.

La première invention a pour objet de prévoir une nouvelle structure de doigt d'émetteur évitant les inconvénients précités des structures connues et permettant d'obtenir des vitesses de commutation à l'ouverture plus grandes. La présente invention vise plus particulièrement le cas de transistors NPN et un procédé de fabrication de tels transistors.

Selon l'invention, il est proposé une structure de doigt d'émetteur dans un transistor de commutation de type NPN, dans laquelle chaque doigt d'émetteur, disposé sous une métallisation d'émetteur, comprend trois zones distinctes en forme de bandes longitudinales dont deux zones latérales présentant une première profondeur de jonction, entourant et en contact avec une zone centrale dont la partie superficielle, s'étendant sur une deuxième profondeur nettement plus faible que la première, est de même type de conductivité que les zones latérales et dont la partie sous-jacente est de type de conductivité opposée, caractérisée en ce que:

— les zones latérales sont dopées au phosphore avec une concentration superficielle supérieure à $10^{20}$ atomes/cm$^3$,

— la partie superficielle de la zone centrale est dopée à l'arsenic,

— la zone centrale complète est dopée à l'or sur une profondeur de l'ordre de celle de la première profondeur de jonction. Selon l'invention, il est également proposé un procédé de fabrication d'un tel doigt d'émetteur.

Ces objets, caractéristiques et avantages ainsi que d'autres de la présente invention seront exposés pluis en détail dans la description suivante de modes de réalisation particuliers faite en relation avec les figures jointes parmi lesquelles:

les figures 1 à 4 destinées à illustrer l'état de la technique ont été décrites précédemment,

les figures 5A à 5E illustrent des étapes de fabrication d'une structure selon la présente invention.

De façon générale, on notera que dans les figures, aucune échelle n'est respectée entre les épaisseurs et les largeurs des diverses couches; au contraire, conformément à l'usage dans le domaine de la représentation des semiconducteurs, les dimensions ont été arbitrairement dilatées dans diverses directions pour faciliter la lisibilité des figures et améliorer leur aspect didactique.

Les figures 5A à 5E illustrent des étapes particulières de fabrication d'un doigt d'émetteur selon la présente invention.

Dans une première étape, illustrée en figure 5A, on forme deux bandes 11 et 12 d'un doigt émetteur par diffusion de phosphore pour obtenir des zones d'émetteur de type $N^+$ présentant une concentration superficielle en atomes dopants supérieure à $10^{20}$ atomes/cm³.

Dans une deuxième étape, illustrée en figure 5B, on masque la structure au moyen d'une couche de silice 20 et on dépose, par exemple par pulvérisation cathodique, une couche d'or 21 comprenant de l'arsenic.

Au cours de l'étape représentée en figure 5C, on procède à un échauffement pour obtenir une couche 22 d'eutectique or/silicium dopée à l'arsenic. On procède ensuite à l'enlèvement de la couche d'or 21 par une attaque à l'eau régale. On notera que l'on aurait également pu enlever la plus grande partie de la couche d'or en dehors des zones situées entre les bandes 11 et 12 avant de procédér à l'étape de formation d'eutectique pour éviter des traversées éventuelles par l'or de la couche de silice 20. Dans ce cas, après la formation de l'eutectique, on enlèvera les portions d'or restantes au-dessus des bandes centrales situées entre les bandes 11 et 12.

Lors de létape illustrée en figure 5D, on procède à nouveau à un échauffement pour faire diffuser dans le silicium l'or et l'arsenic contenus dans la couche eutectique 22, puis l'on procède à l'enlèvement de cet eutectique par une attaque chimique sélective. Comme cela est connu, l'or diffuse plus vite que l'arsenic. On arrête cette étape de diffusion quand l'or a pénétré dans le substrat de silicium d'un profondeur sensiblement égale à la profondeur de jonction des zones d'émetteur 11 et 12. La profondeur de jonction 23 de l'arsenic est alors de l'ordre du cinquième de celle des zones 11 et 12. La zone 24 dopée à l'or est hachurée dans la figure. A titre d'exemple, la concentration superficielle de l'arsenic peut être de quelques $10^{19}$ atomes /cm³ et sa profondeur de jonction de l'ordre de 0,5 à 2 µm tandis que la profondeur de jonction des couches 11 et 12 est de l'ordre de 4 à 10 µm.

Comme le représente la figure 5E, on procède alors à une ouverture supplémentaire de la couche de masquage 20 et au dépôt d'une métallisation d'émetteur 25 recouvrant au moins la partie superficielle des bandes d'émetteur 11 et 12 voisine de la zone centrale.

Ainsi, grâce à l'existence de la zone d'arsenic, il ne peut y avoir de court-circuit entre la métallisation d'émetteur (couramment en aluminium) et la zone de base de type P. En outre, grâce à la présence d'atomes d'or dans la partie intermédiaire entre les zones 11 et 12, le pouvoir d'injection de la partie centrale de l'émetteur constituée par la jonction 23 et par les parties latérales internes 14 et 15 des zones d'emetteur 11 et 12 est pratiquement inhibé. On résout ainsi toutes les difficultés liée aux structure de l'art antérieur décrites précédemment (possibilité de defaut et existence d'une injection résiduelle non négligeable au niveau de la partie centrale du doigt d'émetteur), ce qui élimine sensiblement le phénomene de focalisation des lignes de courant et réduit la durée de commutation à l'ouverture.

La structure a été décrite précédemment dans le cas très particulier où les zones 11 et 12 sont fortement dopées au phosphore et où l'on utilise l'arsenic comme dopant de la zone centrale. Ces caractéristiques constituent un élément de la présente invention. En effet, il convient de choisir des dopants successifs compatibles et sélectifs par rapport à l'or: il faut que l'or diffuse plus vite que le dopant contenu dans la zone centrale et il faut également que le dopant des zones latérales 11 et 12 constitue une barrière pour l'or, ce qui est le cas du phosphore (l'or ne peut diffuser à travers une zone de silicium dans laquelle la concentration en phosphore est supérieure à sensiblement $10^{20}$ atomes/cm³). Ainsi, grâce au choix du phosphore, la largeur de l'ouverture dans la couche de masquage 20 (figure 5B) n'est pas critique et même si cette ouverture déborde un peu sur les portions superficielles centrales des zones 11 et 12, il n'y aura quand même pas de diffusion d'or dans ces zones ce qui nuirait à la qualité de l'injection au niveau des parties utiles de l'émetteur.

La présente invention n'est pas limitée aux modes de réalisations précédemment décrits; elle en englobe au contraire les diverses variantes et généralisations incluses dans le domaine des revendications ci-après.

**Revendications**

1. Structure de doigt d'émetteur dans un transistor de commutation de type NPN, dans laquelle chaque doigt d'émetteur, disposé sous une métallisation d'émetteur, comprend trois zones distinctes en forme de bandes longitudinales dont deux zones latérales (11, 12) présentant une première profondeur de jonction, entourant et en contact avec une zone centrale dont la partie superficielle, s'étendant sur une deuxième profondeur nettement plus faible que la première, est de même type de conductivité que les zones latérales et dont la partie sous-jacente est de type de conductivité opposée, caractérisée en ce que:

— les zones latérales sont dopées au phosphore avec une concentration superficielle supérieure à $10^{20}$ atomes/cm³,

— la partie superficielle de la zone centrale est dopée à l'arsenic,

— la zone centrale complète est dopée à l'or sur une profondeur de l'ordre de celle de la première profondeur de jonction.

2. Structure de doigt d'émetteur selon la revendication 1, caractérisé en ce que la première profondeur de jonction est comprise entre 4 et 10 µm et la deuxième profondeur de jonction est comprise entre 0,5 et 2 µm.

3. Structure de doigt d'émettrur selon la revendication 1, caractérisée en ce que la concentration superficielle en arsenic est de l'ordre de quelques $10^{19}$ atomes/cm³.

4. Procédé de fabrication d'un doigt d'émetteur disposé sous une métallisation et divisé en trois zones longitudinales distinctes, caractérisé en ce qu'il comprend les étapes suivantes:

— former par diffusion de phosphore des zones latérales (11, 12) présentant une concentration superficielle supérieure à $10^{20}$ atomes/cm³,

— masquer la structure par une couche de silice à l'exception de la zone centrale,

— déposer une couche d'or dopée à l'arsenic (21),

— former un eutectique or/silicium (22),

— ôter par attaque chimique la couche d'or,

— procéder à une diffusion simultanée de l'or (24) et de l'arsenic (23) dans la zone centrale, la profondeur de diffusion de l'arsenic étant nettement inférieure à la profondeur de diffusion du phosphore dans les zones latérales et la profondeur de diffusion de l'or étant de l'ordre de la profondeur de diffusion du phosphore dans les zones latérales,

— ouvrir la couche de silice pour rendre apparente la surface des bandes latérales au moins dans des régions adjacentes à la zone centrale, et

— déposer une couche de métallisation (25).

## Patentansprüche

1. Emitter-Fingerstruktur in einem NPN-Schalttransistor, bei welcher jeder unter einer Emittermetallisierung angeordnete Emitterfinger drei getrennte Zonen in Form von Längsstreifen umfasst, wovon zwei seitliche Zonen (11, 12) eine erste Tiefe des Übergangs aufweisen sowie eine zentrale Zone umgeben und berühren, deren Oberflächenteil sich über eine zweite Tiefe erstreckt, die wesentlich geringer als die erste ist, und welche von gleichem Leitungstyp wie die seitlichen Zonen ist, während der darunterliegende Teil von entgegengesetztem Leitungstyp ist, dadurch gekennzeichnet, dass:

— die seitlichen Zonen mit einer Oberflächenkonzentration von mehr als $10^{20}$ Atome/cm³ phosphordotiert sind,

— der Oberflächenteil der zentralen Zone mit Arsen dotiert ist,

— die vollständige zentrale Zone mit Gold über eine Tiefe dotiert ist, die dieselbe Grössenordnung aufweist wie die erste Tiefe des Übergangs.

2. Emitter-Fingerstruktur nach Anspruch 1, dadurch gekennzeichnet, dass die erste Tiefe des Übergangs zwischen 4 und 10 μm und die zweite Tiefe des Übergangs zwischen 0,5 und 2 μm liegt.

3. Emitter-Fingerstruktur nach Anspruch 1, dadurch gekennzeichnet, dass die Arsen-Oberflächenkonzentration in der Grössenordnung von einigen $10^{19}$ Atome/cm³ liegt.

4. Verfahren zur Herstellung eines Emitterfingers, welcher unter einer Metallisierung liegt und in drei getrennte Längszonen unterteilt ist, dadurch gekennzeichnet, dass es folgende Schritte umfasst:

— durch Phosphordiffusion werden seitliche Zonen (11, 12) gebildet, welche eine Oberflächenkonzentration von mehr als $10^{20}$ Atome/cm³ aufweisen,

— die Struktur wird durch eine Siliciumoxidschicht abgedeckt, mit Ausnahme der zentralen Zone,

— eine mit Arsen dotierte Goldschicht (21) wird aufgebracht,

— ein Gold/Silicium-Eutektikum (22) wird gebildet,

— die Goldschicht wird durch chemisches Ätzen entfernt,

— eine gleichzeitige Diffusion von Gold (24) und Arsen (23) wird in der zentralen Zone vorgenommen, wobei die Diffusionstiefe des Arsens deutlich geringer als die Diffusionstiefe des Phosphors in den seitlichen Zonen ist und die Diffusionstiefe des Goldes in der Grössenordnung der Diffusionstiefe des Phosphors in den seitlichen Zonen liegt,

— die Siliciumoxidschicht wird geöffnet, um die Oberfläche der seitlichen Streifen wenigstens in den an die zentrale Zone angrenzenden Bereichen in Erscheinung treten zu lassen, und

— eine Metallisierungsschicht (25) wird aufgebracht.

## Claims

1. Emitter finger structure in a switching transistor of NPN type, wherein each emitter finger is located beneath an emitter zone and comprises three distinct zones in the form of longitudinal strips whereof two lateral zones (11, 12) having a first depth of junction surround and contact a central zone the superficial portion of which extends across a second depth substantially smaller than the first and of the same conductivity type as the lateral zones, and the underlying portion of which is of opposed conductivity type, characterized in that:

— the lateral zones are phosphorus doped at a superficial concentration exceeding $10^{20}$ atoms/cm³,

— the superficial portion of the central zone is arsenic doped,

— the complete central zone is gold doped across a depth of the order of that of the first junction depth.

2. Emitter finger structure according to claim 1, characterized in that the first junction depth is comprised between 4 and 10 μm, and the second junction depth is comprised between 0.5 and 2 μm.

3. Emitter finger structure according to claim 1, characterized in that the superficial arsenic concentration is of the order of some $10^{19}$ atoms/cm³.

4. Method of producing an emitter finger located beneath a metallization and divided into three longitudinal distinct zones, characterized in that it comprises the following steps:

— forming lateral zones (11, 12) by phosphorus diffusion with a superficial concentration exceeding $10^{20}$ atoms/cm³,

— masking the structure with a silica layer except in the central zone,

— deposition of an aresenic doped gold layer (21),

— forming a gold/silicon eutectic (22)

— removing the gold layer by chemical attack,

— preceding with a simultaneous diffusion of gold (24) and of arsenic (23) in the central zone, the diffusion depth of the arsenic being substantially smaller than the diffusion depth of the phosphorus in the lateral zones and the diffusion depth of the gold being of the order of the diffusion depth of the phosphorus in the lateral zones,

— opening of the silica layer so that the surface of the lateral strips becomes apparent at least in the regions adjacent to the central zone, and

— deposition of a metallization layer (25).

**Fig.1**

**Fig.2**

**Fig.3**

**Fig.4**

**Fig.5 A**

**Fig.5 B**

**Fig.5 C**

**Fig.5 D**

**Fig.5 E**